# EUROPEAN PATENT SPECIFICATION

(11) **EP 0 509 771 B1**
(45) Date of publication and mention of the grant of the patent: **15.03.1995**
(21) Application number: 92303364.1
(22) Date of filing: 15.04.1992
(51) Int. Cl.: H01J 37/248, H01J 37/073, H05H 9/00

(54) **High voltage insulation device**
Hochspannungs-Isoliervorrichtung
Dispositif d'isolation haute tension

(30) Priority: 19.04.1991 JP 88108/91
(43) Date of publication of application: 21.10.1992
(73) Proprietor: HITACHI, LTD., Chiyoda-ku, Tokyo 100 (JP)
(72) Inventor: Endo, Junji, Sakado-shi (JP); Kasai, Hiroto, Hiki-gun, Saitama-ken (JP); Kawasaki, Takeshi, Hiki-gun, Saitama-ken (JP)
(74) Representative: Calderbank, Thomas Roger

(56) References cited:
- JP-A- 2 273 443
- JP-U-62 067 455
- US-A- 5 059 859

## Description

This invention relates to the shape of an electrical insulation device, and particularly to a charged-particle acceleration tube which is less subject to high-voltage discharging.

The conventional high voltage insulation device will be explained by taking an example of the acceleration tube used in the electron microscope. The conventional acceleration tube for the electron microscope is formed of a number of insulation members (cylinders of porcelains or ceramics). These insulation members, each provided on both ends with a conductive film (formed by a metalizing process), are connected in tandem by brazing through conductive members (metallic electrode supporting plates) to complete a multi-stage acceleration tube, as described in JP-U-62-67455 (printed publication of Japanese Utility Model Application Laid-Open No.62-67455).

The above-mentioned printed publication is based on the fact that small discharging which emerges in a small gap at the edge of the conductive film grows into large discharging, and is intended to prevent the emergence of high-voltage discharging by forming a metalized layer which slightly juts out onto the connection surface on both ends of the insulating cylinder. Although this prior art is conceivably effective for the prevention of small discharging from the electrode support plate to the insulating cylinder through the gap at the edge of the metalized layer, small discharging is more liable to emerge from the conductive member inclusive of the electrode support plate and metalized layer, particularly a protrudent portion where the electric field concentrates, to the insulating cylinder. The above-mentioned prior art is not concerned about small discharging of this type, and discharging due to the formation of protrusions by the jut-out metalized layer is not dealt with.

The present invention is intended to provide a high-voltage insulation structure which suppresses the emergence of small discharging and also suppresses small discharging from growing into large discharging.

This object is achieved by a high-voltage insulation device according to claim 1 or 5.

According to one aspect of the present invention, a joint surface portion of an end portion of an insulating member (corresponding to that joint portion of the cylindrical insulator in the above-mentioned prior art which is relatively kept negative with respect to the other) to a conductive member is formed to be generally T-shaped in its longitudinal section, and an elevated part of the sectionally T-shaped end portion of the insulating member is used as a joint surface with the conductive member, and grooves are formed at steps, from which the elevated part of the sectionally T-shaped end portion of the insulating member extends and wherein the depthwise direction of the grooves is substantially opposite to the direction (in the conventional sense) of an electric field to which the insulating member may be subjected.

Furthermore, by provision of conductive coatings on the joint surface and a side surface of the elevated part of the sectionally T-shaped end portion of the insulating member and on the grooves, the effect of the present invention will be much enhanced.

Furthermore, similar effect will be expected when the joint surface portion of at least one of the end portions of an insulating member which is kept at a relatively negative voltage with respect to the other is formed to be generally U-shaped in its longitudinal section, which may result from expansion of the above-mentioned grooves to consume the elevated part, and a conductive coating is formed on the inner surface of the sectionally U-shaped end portion of the insulating member.

It is known in the art that a solid insulation material has a significantly smaller insulation ability on its surface as compared with the internal portion. On this account, for the prevention of high-voltage discharging, it is necessary for the insulator surface to be retardative against the emergence of small discharging, and retardative against the growth of small discharging into large discharging. In the structure of the conventional insulation device, the metalized layer and brazing material have their ends extending virtually in the direction of electric field, and therefore it is likely to have on an end surface in a relatively negative potential side: (1) the emergence of small discharging in gaps at the edge of the metalized layer, and (2) the acceleration of electron streams and secondary electrons created by the small discharging toward the relatively positive potential side due to the direction of the insulating cylinder wall close to the direction of electric field, which promotes small discharging to grow into large discharging.

According to a feature of the present invention, electron streams and secondary electrons created by small discharging at ends of conductive members including the coating are unlikely to grow into large discharging because the direction of discharge path along the wall of the insulation member necessarily includes a portion being opposite to the direction of electric field due to the provision of the grooves. Particularly, further provision of conductive coatings on the top surface and side surfaces of the sectionally T-shaped end portion of the insulation member which is kept at a relatively negative potential with respect to the other end portion of the insulation member and on the inner surface of the grooves results in: (1) unlikeliness of the emergence of small discharging since any gap at an end or edge of the conductive coating or similar conductor on the insulation member forms a wall for a discharge in a direction virtually opposite to the direction of electric field and the electric field at the end of the insulation member is weakened by the presence of the conductor in the groove, and (2) unlikeliness of the growth of small discharging into large discharging since the wall surface of the insulation member has a direction which is greatly different from the direction of electric field and the electric field is weakened by the same reason as mentioned in item (1), and accordingly secondary electrons created by small discharging are not much accerelated.

The invention will be better understood from the following description.

In the drawings:
Fig. 1 is a longitudinal sectional diagram showing the first embodiment of this invention applied to an electron gun;
Fig. 2 is a longitudinal sectional diagram showing the whole electron gun based on the first embodiment of this invention;
Fig. 3 is a longitudinal sectional diagram showing the details of part of the electron gun based on the second embodiment of this invention; and
Fig. 4 is a longitudinal sectional diagram showing the details of part of the electron gun based on the third embodiment of this invention.

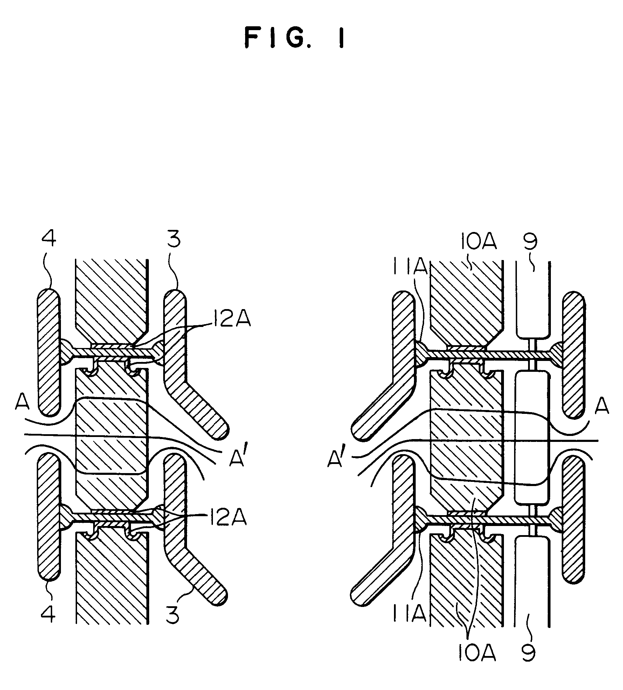

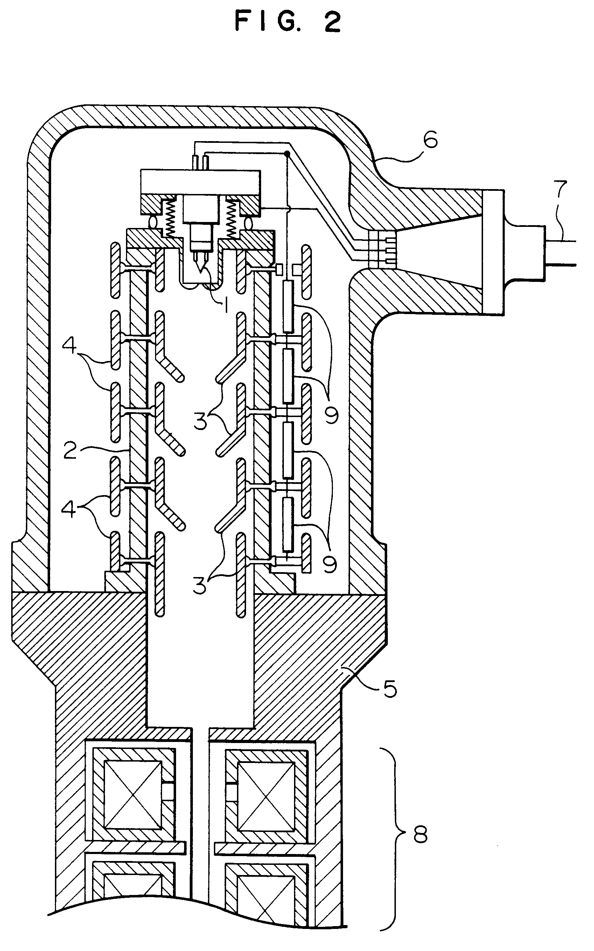

An embodiment of this invention will be explained with reference to Fig. 1 and Fig. 2. This embodiment is an application of this invention to a multi-stage electron gun which is used in electron beam apparatus and the like.

Fig. 2 is a longitudinal sectional diagram of the multi-stage electron gun. This electron gun has a vacuum chamber made up of an electron gun vacuum chamber 5 located above the electron microscope column or cylinder 8 and an acceleration tube 2 located above the vacuum chamber 5, and the inner space of the gun is evacuated from the vacuum chamber through the electron gun vacuum chamber or electron microscope cylinder by means of a vacuum pump (not shown). An electron beam source 1 and acceleration electrodes 3 are disposed inside the acceleration tube, and discharge-preventive electrodes 4 for individual stages are fixed on the external wall of the acceleration tube. The acceleration tube section is covered by a high-voltage insulation chamber 6 which is filled with insulating gas such as hexafluorsulfur. High voltage power to be applied to the electron beam source of the electron gun is supplied from a high-voltage power source (not shown) into the high-voltage insulation chamber 6 through a high-voltage cable 7. The supplied high voltage is also applied to the acceleration electrodes 3 and discharge-preventive electrodes 4 by being divided by voltage division resistors 9 placed between acceleration tubes of adjacent stages. This embodiment of invention is applied to the insulation device which constitutes the acceleration tube.

Fig. 1 is a longitudinal sectional diagram showing the details of part of the acceleration tube of the electron gun shown in Fig. 2. The acceleration tube includes a plurality of insulating cylinders 10A each having a top joint section, which is on a relatively negative potential side, formed to be generally T-shaped in its longitudinal section. Each cylindrical member 10 (which forms a acceleration tube 2) has conductive coatings 12A on the top surface and side surfaces of the elevated part of the sectionally T-shaped joint section and on the inner surface of grooves formed on the step to the elevated part. A number of such insulation members are connected in tandem by brazing through conductive members 11A. The conductive member 11A is eccentric for the inner and outer diameters, and it is provided with an acceleration electrode 3 in the inner side, a discharge-preventive electrode 4 on the outer side, and a voltage division resistor 9 in the space between the insulation member 10A and discharge-preventive electrode 4. Curves A-A′ show equi-potential lines in the periphery of these components. It is a well-known fact that electrons are subjected to a force and accelerated in the positive direction perpendicular to the equi-potential lines.

In the acceleration tube of this structure, discharging is liable to emerge at the portion between the conductive member 11A and insulation member 10A which is exposed to the vacuum or insulating gas, i.e., the edge of the conductive coating 12A. This portion is prone to have a small gap, as is well known in the art. Even a low voltage applied across the small gap produces an extremely large electric field, promoting the emergence of small discharging. When an electron stream created by the small discharging is accelerated toward a relatively positive potential region, it grows into a large electron stream while generating secondary electrons in the insulation member and reaches the counter positive electrode, resulting in a large discharging. The edge of the conductive member does not always have a smooth finish, but it often has a formation of small roughness. This protrusion is prone to have a concentrated electric field, which serves as a discharging source to generate an electron stream in many cases. The electron stream, when accelerated, can develop into large discharging through the same process as mentioned previously.

According to this embodiment, the electric field at the small protrusions or small gaps formed at edges of the conductive coatings is relaxed by the conductive coatings on the grooves, and this structure suppresses the emergence of small discharging from the beginning. Even in the emergence of discharging at the small protrusions or small gaps formed at the edges of the conductive coatings, it scarcely develops into large discharging, since the direction of acceleration of the electron stream is far different from the direction of the surface of insulation device along which a discharge path is formed. The structure of this embodiment is also advantageous significantly for the fabrication of multi-stage acceleration tubes. In the structure of the conventional multi-stage acceleration tube, a brazing material used to bond the conductive coating to the conductive member often flows onto the surface of insulation member, and this brazing material forms a protrusion in the direction of electric field, causing apparently the emergence of discharging. Whereas, according to the structure of this embodiment, flowing brazing material is blocked by the groove, and the formation of protrusions can be prevented.

For the acceleration of electrons, as in the case of an electron gun, a portion nearer to the electron beam source has relatively negative potential, and for this reason the joint section at the top of the insulation member is formed to be generally T-shaped in its longitudinal section and grooves are formed downward the elevated part on the step section according to this invention. The bottom of the insulation member 10A may be formed in the same shape. For apparatus designed to accelerate positively charged particles, the foregoing shape of longitudinal section is adopted for the portion of insulation member far from the source of the charged particle beam. Although in this embodiment the interior of the groove is provided with a conductive coating, it may be filled with conductive material to achieve the same effectiveness.

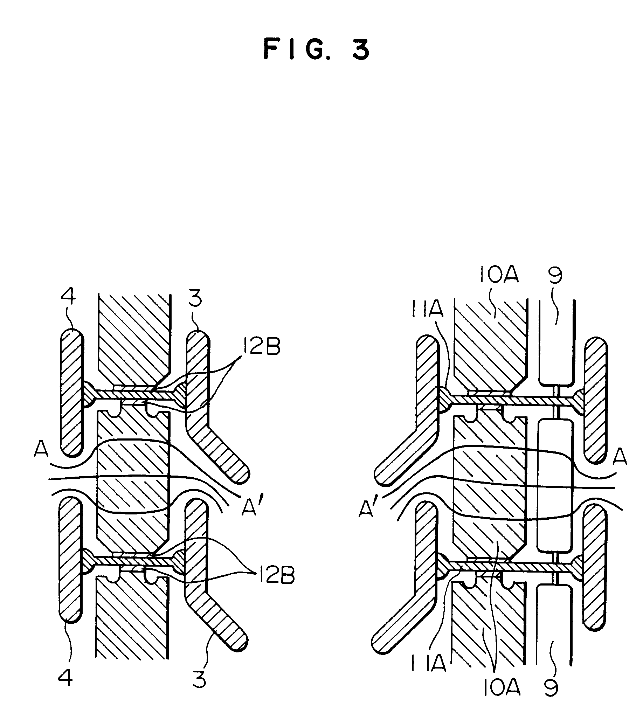

Fig. 3 shows a second embodiment of this invention which is applied to an electron gun as in the previous embodiment. The figure is a longitudinal sectional view of the joint section of acceleration tubes. In the second embodiment, the top of the cylindrical insulation member 10A is formed to be generally T-shaped in its longitudinal section, conductive coatings 12B are formed on the top surface of the elevated part of the sectionally T-shaped one end portion of the insulation member 10A and on the other end portion of the insulation member, but side surfaces of the elevated part and the interior of the groove are not provided with the conductive coating. A complete acceleration tube is formed of a number of cylindrical insulation members 10A connected in tandem by brazing by being interleaved by conductive members 11A each placed between the top surface of the elevated part of the one end portion of an insulation member and the bottom surface of the other end portion of the overlying or upper insulation member. Acceleration electrodes 3 are fixed on the interior side of the conductive member 11A and discharge-preventive electrodes 4 are fixed on the exterior side, as in the first embodiment. Also in this embodiment, the portion liable to incur small discharging is the edge of the conductive coating 12B, and equi-potential lines are as shown by the curves A-A′. Since the edge of the conductive coating 12B faces in a direction close to the direction of electric field, the discharge prevention effect is somewhat inferior as compared with the first embodiment. However, although an electron stream created by small discharging is accelerated down to the bottom of the groove, the direction of electric field differs significantly from the wall plane of the insulation device at positions beyond the bottom, and therefore electrons created by discharging scarcely reach the positive electrode and thus this discharges scarcely grow into large discharges.

The acceleration tube of this embodiment needs to have a tight vacuum sealing structure, and the conductive member is brazed to the top surface of the elevated part through the conductive coating process. In case hermetic sealing is not required, the conductive coating may be eliminated in exchange for a degraded effectiveness.

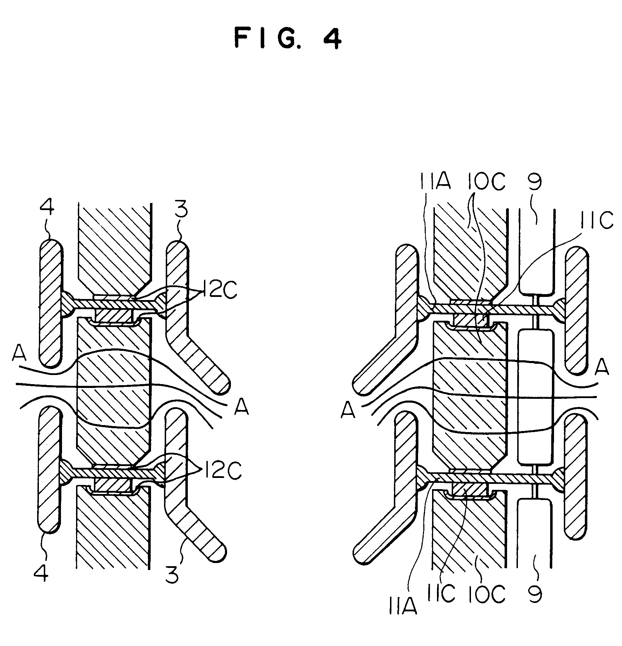

Fig. 4 is a longitudinal sectional diagram of another embodiment of this invention, showing the details of part of the electron beam acceleration apparatus. Also in this embodiment, a complete acceleration tube is formed by connecting cylindrical insulation members 10C in tandem through conductive members 11A and conductive spacers 11C. Acceleration electrodes 3 and discharge-preventive electrodes 4 are fixed on the interior side and exterior side, respectively, of the conductive members 11A and conductive spacers 11C. The joint section or one end portion of the insulation member 11C in connection with the conductive member 11A and conductive spacer 11C, which joint section or end portion is held at a relatively negative voltage with respect to the other joint section or the other end portion is formed to be generally U-shaped in its longitudinal section, and its inner surface is provided with a conductive coating 12C. Thus, the conductive spacer 11C is disposed between the bottom surface of the U-shaped end portion and the conductive member 11A. This embodiment is a variant of the first embodiment, by replacing the elevated portions of the insulation members by the conductive spacers 11C. The bottom surface of the sectionally U-shaped end portion of the insulation member 10C is kept at the same potential level as the conductive member 11C. The other joint section or end portion of the insulation member may also have the same structure as described. The performance and effectiveness of discharge prevention and the advantage for fabrication are all identical to the first embodiment.

According to the invention, when an electron stream is created by small discharging at one end of the high-voltage insulation member, it must pass through a region of electric field of opposite or near-opposite direction before reaching another end by traveling over the surface of the insulation member. Accordingly, the structure effectively prevents small discharging from growing into large discharging.

The formation of a small gap at the contact joint section between the high-voltage insulation member and conductive member is relieved, and therefore it suppresses generation of small discharging and thus further enhances the discharge-preventive effect.

The contact joint section of the high-voltage insulation member and conductive member has its opening direction made different significantly from the direction of electric field, and the electric field itself is relaxed by the conductive coating or conductive filler. Therefore, the structure suppresses generation of small discharging and the acceleration of created electron streams, and it further enhances the discharge-preventive ability.

Although the foregoing embodiments are multi-stage acceleration tubes of an electron microscope, this invention is not limited to this application, but similar effectiveness is expected when applied to general insulators and the insulation structure of electric circuits.

## Claims

1. A high-voltage insulation device having one end portion in contact with or joined to a conductive member (11A) on a higher voltage side and another end portion in contact with or joined to another conductive member (11A) on a lower voltage side, wherein at least the one of said end portions of said insulation device which is held at a voltage relatively negative with respect to the other end portion is formed to be generally T-shaped in its longitudinal section to provide an elevated part, said elevated part having a surface in contact with or joined to the conductive member, wherein a groove is formed on a step from which the elevated part extends and the depthwise direction of the groove is substantially opposite to the direction (in the conventional sense) of an electric field to which the insulation device may be subjected.

2. A high-voltage insulation device according to claim 1, wherein a conductive coating (12B) is formed on said surface of the elevated part.

3. A high-voltage insulation device according to claim 1, wherein a conductive coating (12A) is formed on said surface of the elevated part, a side surface of said elevated part and said groove.

4. A high-voltage insulation device according to claim 1, wherein a conductive coating (12A) is formed on said surface of the elevated part and side surfaces of said elevated part, and conductive material is placed in said groove.

5. A high-voltage insulation device having one end portion made in contact with or joined to a conductive member (11A) on a higher voltage side and another portion made in contact with or joined to a conductive member (111A) on a lower voltage side, wherein at least the one of said end portions of said insulation device which is held at a potential relatively negative with respect to the other end portion is formed to be generally U-shaped in its longitudinal section, said U-shaped end portion having a bottom surface which is kept at the same potential level as the conductive member, and a conductive coating (12C) is formed on the inner surface of said U-shaped end portion.

6. A high-voltage insulation device according to claim 5, wherein a conductive spacer (11C) is disposed between said bottom surface of said U-shaped end portion and the conductive member.

## Patentansprüche

1. Hochspannungs-Isoliervorrichtung mit einem Endabschnitt in Kontakt oder Verbindung mit einem leitenden Teil (11A) auf einer Seite höherer Spannung und einem anderen Endabschnitt in Kontakt oder Verbindung mit einem anderen leitenden Teil (11A) auf einer Seite niedrigerer Spannung, wobei zumindest der eine der Endabschnitte der Isoliervorrichtung, der auf einer relativ negativen Spannung in bezug auf den anderen Endabschnitt gehalten wird, so ausgebildet ist, daß er im Längsschnitt im wesentlichen T-förmig ist, um einen erhöhten Teil zu schaffen, der eine Oberfläche in Kontakt oder Verbindung mit dem leitenden Teil aufweist, wobei in der Stufe, von der aus sich der erhöhte Teil erstreckt, ein Graben ausgebildet ist und wobei die Tiefenrichtung des Grabens im wesentlichen entgegengesetzt zur Richtung (im Definitionssinn) eines elektrischen Felds ist, dem die Isoliervorrichtung ausgesetzt sein kann.

2. Hochspannungs-Isoliervorrichtung nach Anspruch 1, bei der eine leitende Beschichtung (12B) auf der Oberfläche des erhöhten Teils ausgebildet ist.

3. Hochspannungs-Isoliervorrichtung nach Anspruch 1, bei der eine leitende Beschichtung (12A) auf der Oberfläche des erhöhten Teils, einer Seitenfläche des erhöhten Teils und dem Graben ausgebildet ist.

4. Hochspannungs-Isoliervorrichtung nach Anspruch 1, bei der eine leitende Beschichtung (12A) auf der Oberfläche des erhöhten Teils und Seitenflächen des erhöhten Teils ausgebildet ist und leitendes Material im Graben angebracht ist.

5. Hochspannungs-Isoliervorrichtung mit einem Endabschnitt, der in Kontakt oder Verbindung mit einem leitenden Teil (11A) auf einer Seite höherer Spannung gebracht ist, und mit einem anderen Abschnitt, der in Kontakt oder Verbindung mit einem leitenden Teil (111A) auf einer Seite niedrigerer Spannung gebracht ist, wobei zumindest der eine der Endabschnitte der Isoliervorrichtung, der auf relativ negativem Potential in bezug auf den anderen Endabschnitt gehalten wird, im Längsschnitt im wesentlichen U-förmig ausgebildet ist, wobei der U-förmige Endabschnitt eine Bodenfläche aufweist, die auf demselben Potentialniveau wie das leitende Teil gehalten wird, und wobei eine leitende Beschichtung (12C) auf der Innenfläche des U-förmigen Endabschnitts ausgebildet ist.

6. Hochspannungs-Isoliervorrichtung nach Anspruch 5, bei der ein leitender Abstandhalter (11C) zwischen der Bodenfläche des U-förmigen Endabschnitts und dem leitenden Teil angeordnet ist.

## Revendications

1. Dispositif d'isolation haute tension dont une partie d'extrémité est en contact avec ou reliée à un élément conducteur (11A) sur un côté de tension plus élevée et dont l'autre partie d'extrémité est en contact avec ou reliée à un autre élément conducteur (11A) sur un côté de tension inférieur, dans lequel au moins l'une desdites parties d'extrémité dudit dispositif d'isolation qui est maintenu à une tension relativement négative par rapport à l'autre partie d'extrémité a une forme généralement en T dans sa section longitudinale pour fournir une partie élevée, ladite partie élevée ayant une surface en contact avec ou reliée à l'élément conducteur, dans lequel une rainure est ménagée sur un gradin depuis lequel la partie élevée s'étend, et la direction en profondeur de la rainure est sensiblement opposée à la direction (dans le sens classique) d'un champ électrique auquel le dispositif d'isolation peut être soumis.

2. Dispositif d'isolation haute tension selon la revendication 1, dans lequel un revêtement conducteur (12B) est formé sur ladite surface de la partie élevée.

3. Dispositif d'isolation haute tension selon la revendication 1, dans lequel un revêtement conducteur (12A) est formé sur ladite surface de la partie élevée, une surface latérale de ladite partie élevée et ladite rainure.

4. Dispositif d'isolation haute tension selon la revendication 1, dans lequel un revêtement conducteur (12A) est formé sur ladite surface de la partie élevée et les surfaces latérales de ladite partie élevée, et le matériau conducteur est placé dans ladite rainure.

5. Dispositif d'isolation haute tension dont une partie d'extrémité est réalisée pour être en contact avec ou reliée à un élément conducteur (11A) sur un côté de tension plus élevé et dont une autre partie est réalisée pour être en contact avec ou reliée à un élément conducteur (11A) sur un côté de tension plus basse, dans lequel au moins celle desdites parties d'extrémité dudit dispositif d'isolation qui est maintenu à un potentiel relativement négatif par rapport à l'autre partie d'extrémité est réalisée suivant une forme généralement en U dans sa section longitudinale, ladite partie d'extrémité en forme de U ayant une surface de fond qui est maintenue au même niveau de potentiel que l'élément conducteur, et un revêtement conducteur (12C) est formé sur la surface intérieure de ladite partie d'extrémité en forme de U.

6. Dispositif d'isolation haute tension selon la revendication 5, dans lequel une pièce d'écartement conductrice (11C) est disposée entre ladite surface de fond de ladite partie d'extrémité en forme de U et l'élément conducteur.
